# EUROPEAN PATENT APPLICATION

(11) **EP 0 932 200 A2**
(43) Date of publication of application: **28.07.1999**
(21) Application number: 98480071.4
(22) Date of filing: 29.10.1998
(51) Int. Cl.: H01L 23/40, H01L 23/60

(54) **Heat sink device for microprocessor**

(30) Priority: 22.01.1998 EP 98480005
(71) Applicant: International Business Machines Corporation, Armonk, N.Y. 10504 (US)
(72) Inventor: Baron, Dominique, 06140 Vence (FR); Braquet, Henri, 06790 Aspremont (FR); Boniface, Henri, 06610 La Gaude (FR); Centola, Bruno, 06140 Vence (FR)
(74) Representative: Etorre, Yves Nicolas

(57) **Abstract**

Heat sink device (24) for a microprocessor (20) installed on a printed circuit board (22) including a ground plane (34), such a device being thermally conductive and fixed on the top of the dielectric case incorporating the microprocessor and including an outer surface enabling heat exchange with the ambient air. The heat sink device (24) comprises radiation blocking means of the Faraday type for preventing the device operating as an antenna from re-emitting electromagnetic radiation which is received from microprocessor (20) and connecting means (28, 30, 32) for connecting the device to ground plane (34) in order to evacuate the energy induced by the electromagnetic radiation.

## Description

### Technical field

The present invention relates to heat sinks for semi-conductor components installed on a printed circuit board and particularly to a heat sink device for a microprocessor preventing electromagnetic disturbance generated by said microprocessor.

### Background art

The electronic business and the success of multimedia application software have led the industry to develop a new generation of high speed microprocessors for providing the users with larger bandwidth and throughput to exchange, pull back and forth large data files. These microprocessors with a power of about 7 to 10 watts are energy consuming, and need for reliable heat sinks to dissipate this energy.

In the same time, technology progress and logic circuiting integration allow high speed cell switching which results in electromagnetic energy radiation. Generally, the heat sink, made of a thermal conductive material such as steel or aluminum alloy, is installed on the top of the dielectric case incorporating the microprocessor and captures a part of the electromagnetic radiation generated by the microprocessor.

As the thermal exchange with the air requires to have an important heat exchange area, the top of heat sink is generally composed of a plurality of fins or spikes resulting in an area being between 4 and 10 times the area of the microprocessor. But, such fins behave as an antenna which re-emits electromagnetic radiation it has captured. This radiation can disturb the logic circuits located in the vicinity and it becomes very difficult to meet the requirements of the EMC standards. A technique used to overcome this problem consists in covering the microprocessor with a Faraday cage which results, unfortunately, in a poor cooling management.

### Summary of the invention

Therefore, the object of the invention is to provide a metallic heat sink for a semi-conductor component installed on a printed circuit board which does not emit electromagnetic radiation which could disturb the operation of the logic circuitry installed on the printed circuit board.

Accordingly, the invention relates to a heat sink device for a microprocessor installed on a printed circuit board including a ground plane, such a heat sink device being thermally conductive and fixed on the top of the dielectric case incorporating the microprocessor and including an outer surface enabling heat exchange with the ambient. This device comprises radiation blocking means for preventing the heat sink device operating as an antenna from re-emitting electromagnetic radiation which is received from the microprocessor and connecting means for connecting the heat sink device to the ground plane in order to evacuate the energy induced by the electromagnetic radiation.

In a preferred embodiment of the invention, the heat sink device has the function of a Faraday cage with connecting pins directly connected to the ground plane of the board.

### Brief description of the drawings

Fig. 1 is a schematic representation of a microprocessor case fitted up with classical heat sink emitting electromagnetic radiation, and
Fig. 2 is a partial cross-section of a microprocessor case fitted up with a heat sink according to the invention.

### Detailed description of the invention

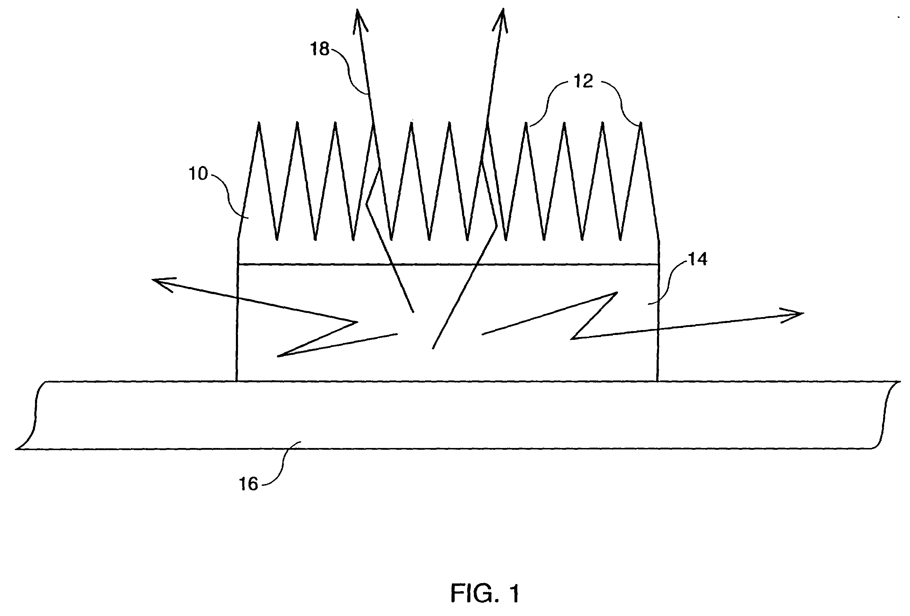

A classical heat sink as illustrated in Fig. 1 is a thermal conductive device 10, generally in steel or aluminum alloy, principally composed of fins or spikes 12 which present a very important area enabling the heat generated by microprocessor 14 to be dissipated in the ambient air.

Microprocessor 14 installed on printed circuit board 16 is incorporated in a dielectric case. Dire to this dielectric case, the microprocessor is capacitively coupled with the microprocessor chip. Then, heat sink fins 12 are coupled to the environment thru their parasitic capacitance. Therefore, a part of the electromagnetic energy captured by heat sink 10 due to such a capacitance is re-emitted by fins 12 operating as an antenna.

The emission of electromagnetic radiation represented by arrows 18 in Fig.1 depends on the size of fins 12 compared with the wavelength of the harmonics generated by microprocessor chip. The rule of thumb indicates that fins having a length above one tenth of the wavelength become an antenna. Thus, it is the case with fins having a length of about 10mm which constitute an antenna for the harmonics of 3 GHz and above.

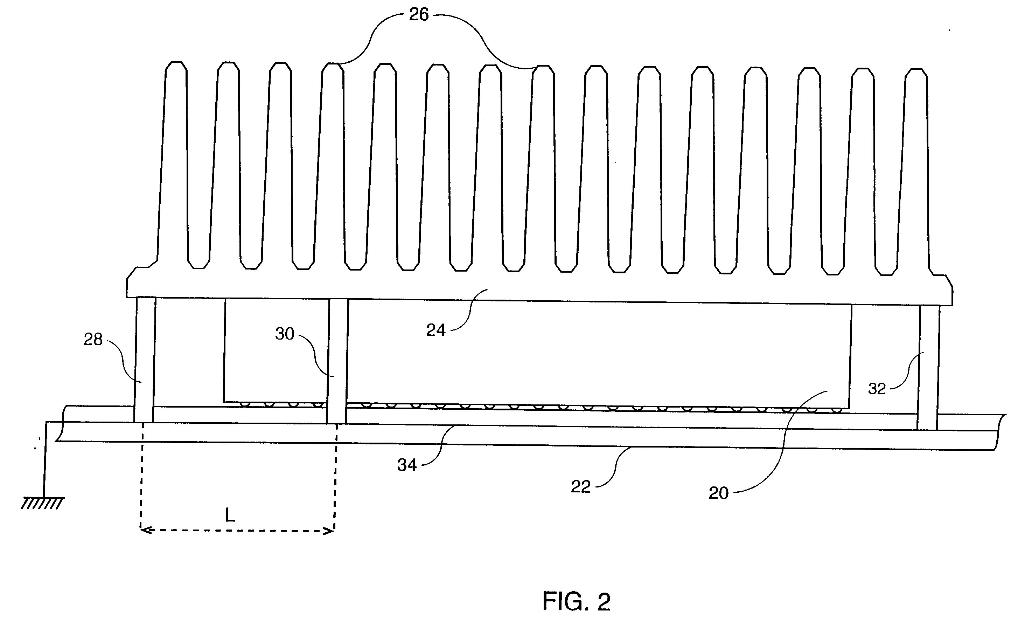

The above problem is overcome by a heat sink device illustrated in Fig. 2. As already mentioned, microprocessor 20 incorporated in a dielectric case is installed on a printed circuit board 22. A thermal conductive heat sink 24 principally composed of fins 26 is fixed on the top of microprocessor 20 preferably with a thermal conductive glue. It must be noted that the height of fins 26 and the space therebetween is designed in such a way to provide as much as possible thermal exchange between microprocessor 20 and the ambient air for heat dissipation.

Differently from the classical heat sink of Fig.1, heat sink 24 is larger than microprocessor 20. In fact, the latter is encapsulated in a Faraday cage constituted by heat sink 24 on the top and vertical pins such as pins 28, 30 or 32, which are regularly spaced and connected to the ground plane 34 of the printed circuit board 22. Thus, most of the radiation energy captured by heat sink 24 is dissipated by the ground plane 34.

The number of pins 28, 30 or 32 depend primarily on the highest harmonic wavelength and the rule of thumb is to have spacing L between two pins equal or less than one tenth of the lowest wavelength. Thus, with modern modules which exhibit significant harmonics of 3 GHz, corresponding to the 10th harmonic of signals having a fundamental of 200 to 300 MHz currently used, the spacing L must be less than 1cm. An example of implementation with a microprocessor case being 5cm large is a Faraday cage having a side of 8cm and comprising 9 pins such as pins 28, 29 and 30. The object of the invention is to provide a radiation blocking device of the Faraday cage type maintaining the electromagnetic emissions inside and being composed of the ground plane, the top constituted by fins or spikes for dissipation the heat and walls preventing the radiation of the smallest wavelengths to be emitted outside. It must be noted that such a device could be implemented differently from the above described device. Thus, the Faraday cage could have solid sidewalls instead of pins, such sidewalls being connected to the ground directly on the top of the printed circuit board or by pinholes, or could be formed by a grid the mesh of which being of a dimension less than the tenth of the smallest wavelength as mentioned above. At last, it would be possible that the connection of heat sink 24 to ground plane 34 be a single strap or wire different from pins 28, 30, or 32.

## Claims

1. Heat sink device (24) for a semi-conductor component (20), in particular a microprocessor, installed on a printed circuit board (22) including a ground plane (34), said device being thermally conductive and fixed on the dielectric case incorporating said semi-conductor component and including an outer surface enabling heat exchange with the ambient air ; said heat sink device being characterized in that it comprises
- radiation blocking means (28, 30, 32) for preventing the heat sink device operating as an antenna from re-emitting electromagnetic radiation which is received from said semi-conductor component, and
- connecting means for connecting the heat sink device to said ground plane in order to evacuate the energy induced by said electromagnetic radiation.

2. Heat sink device (24) according to claim 1, wherein said radiation blocking means are a Faraday cage comprising connecting pins (28, 30, 32) directly connected to said ground plane (34).

3. Heat sink device (24) according to claim 2, wherein said connecting pins (28, 30, 32) are regularly spaced, the spacing L between two of said pins being less than the tenth smallest electromagnetic radiation wavelength to be prevented from being re-emitted.

4. Heat sink device (24) according to claim 3, wherein said spacing L is less than 1cm in order to prevent electromagnetic radiation harmonics up to 3 GHz from being re-emitted.

5. Heat sink device (24) according to any of claims 1 to 4, wherein said outer surface enabling heat exchange with the ambient air is composed of fins (26).
